# FASCICULE DE BREVET EUROPEEN

(11) **EP 2 710 168 B1**
(45) Date de publication et mention de la délivrance du brevet: **20.12.2017**
(21) Numéro de dépôt: 12728712.6
(22) Date de dépôt: 16.05.2012
(51) Int. Cl.: C23C 28/04, C23C 14/02, C23C 14/06

(54) **PIECE AVEC REVETEMENT DLC ET PROCEDE D'APPLICATION DU REVETEMENT DLC**
TEIL MIT EINER DIAMANTARTIGEN KOHLENSTOFF BESCHICHTUNG (DLC) UND VERFAHREN ZUR AUFTRAGUNG DER DIAMANTARTIGEN KOHLENSTOFF BESCHICHTUNG (DLC)
ARTICLE WITH A DLC COATING AND METHOD FOR THE APPLICATION OF THE DLC COATING

(30) Priorité: 19.05.2011 FR 1154388
(43) Date de publication de la demande: 26.03.2014
(73) Titulaire: H.E.F., 42160 Andrezieux-Boutheon (FR)
(72) Inventeur: HEAU, Christophe, F-SAINT-ETIENNE 42100 (FR); BOMBILLON, Laurent, F-42160 Andrezieux Boutheon (FR); MAURIN-PERRIER, Philippe, F-42680 Saint-Marcellin-en-Forez (FR)
(74) Mandataire: Cabinet Laurent & Charras
(86) Numéro de dépôt international: PCT/FR2012/051109
(87) Numéro de publication internationale: WO 2012/156647

(56) Documents cités:
- EP-A1- 2 362 000
- DE-A1-102007 058 356
- REBHOLZ: "Deposition and characterisation of carbon-containing tungsten coatings prepared by reactive magnetron sputtering", VACUUM, vol. 49, no. 4, 1 janvier 1998 (1998-01-01), page 265, XP055014773, ISSN: 0042-207X

## Description

L'invention se rattache au secteur technique des revêtements DLC notamment pour pièces de frottement.

L'invention trouve une application particulièrement avantageuse pour réduire le coefficient de frottement, par exemple des axes de piston, arbres à came, poussoirs, cylindres, segments....., et plus généralement, dans tous les cas de frottement chargés. Pour réduire ce frottement, il est parfaitement connu pour un homme du métier de soumettre la ou les pièces concernées à un revêtement DLC.

L'invention peut aussi trouver des applications dans lesquelles on recherche une couleur noire de la surface apportée par le revêtement sans pour autant chercher une réduction de frottement.

Il ressort également des connaissances générales de l'homme du métier que la faible adhérence des films DLC sur les pièces, peut poser de réels problèmes pour certaines applications. Pour améliorer l'adhérence, une solution technique consiste à utiliser une sous-couche métallique d'accroche à base par exemple de silicium ou de chrome. Différentes solutions techniques ont été proposées.

Par exemple, le document WO2011/018252 décrit avec une pièce de frottement un revêtement constitué d'une sous-couche d'accroche, d'un revêtement métallique DLC et d'un revêtement DLC sans métal. La couche d'accroche est préférentiellement un revêtement de chrome d'épaisseur maximum de 1µm tandis que le revêtement métallique DLC est préférentiellement du carbure de tungstène WCC. Les rapports d'épaisseur des différentes couches et revêtements sont limités à des plages de valeurs de sorte qu'en dehors de ces plages, si l'épaisseur de DLC est trop faible, la durée de vie de la pièce sera également réduite tandis que si l'épaisseur de DLC est trop importante, la pièce aura une usure prématurée avec des risques d'écaillage.

Le document WO0179585 divulgue un système multicouches ayant une couche d'accroche, une couche de transition et une couche de carbone adamantin. La couche d'accroche comprend un élément du groupe 4, 5 ou 6 et du silicium, tandis que la couche de transition comprend du carbone ou au moins un élément du groupe 4, 5, ou 6 et du silicium. La couche supérieure est principalement du carbone adiamantin. Le système a une dureté d'au moins 15 GPa et une adhérence d'au moins HF3.

D'une manière générale, on observe une délamination du film de DLC vis-à-vis de cette sous-couche liée aux contraintes internes du film de DLC qui augmente avec l'augmentation de l'épaisseur d'un tel film. On observe également que la formation de cette sous-couche d'accroche est effectuée dans une étape séparée ce qui augmente les coûts du procédé tout en compliquant un tel procédé.

DE102007058356 divulgue une pièce métallique et sa méthode de fabrication, la pièce présentant une sous-couche d'implantation ionique, une couche à gradient de composition WC et une couche superficielle de DLC. Selon l'enseignement de ce document, le décapage s'effectue avec des ions W+ et C+. La solution définie dans DE102007058356 présente des désavantages notamment du fait des ions qui, pour décaper, nécessitent des tensions beaucoup plus élevées qu'avec des ions argon afin que les ions ne forment pas un dépôt et donc que l'on décape bien la pièce.

L'invention s'est fixée pour but de remédier à ces inconvénients de manière simple, sure, efficace et rationnelle.

Le problème que se propose de résoudre l'invention est de réaliser des films de DLC ayant une adhérence améliorée sans pour autant utiliser une sous-couche d'accroche métallique, silicium ou chrome par exemple, comme il ressort de l'enseignement de l'état de la technique.

Pour résoudre un tel problème, il a été conçu et mis au point, une pièce métallique présentant une couche à gradient de composition WC-C, à l'exception d'une sous-couche métallique, et une couche superficielle de DLC, caractérisée par un comportement cohésif en scratch test.

Le problème posé est avantageusement résolu par un procédé, selon lequel :
- on réalise un décapage micro-onde de la pièce ;
- on soumet la pièce à une couche à gradient de composition WC-C ;
- on applique sur la couche WC-C le revêtement DLC par plasma micro-onde ;

Le décapage micro-onde permet par rapport à un décapage utilisant la technologie diode, d'obtenir un décapage plus efficace et indépendant de la géométrie de la pièce à traiter par l'ajustement du flux d'ions. Il est également possible de réaliser un décapage sur des pièces à basse température de revenu, sans les altérer. On observe également que l'utilisation d'un revêtement DLC micro-onde, permet de réduire le temps du procédé d'application d'environ 50 %, par rapport à un DLC classique.

Avantageusement, on génère un plasma d'argon pour le décapage dans une plage de pression, comprise entre 0,05 et 0,5 Pa.

Selon une autre caractéristique, on réalise la couche à gradient de composition WC-C par technique PVD magnétron. On part d'une première couche de WC pur suivie d'une rampe avec un gaz hydrocarbure comme le C₂H₂ et suivie en final d'une couche WC-C. L'épaisseur de la couche à gradient de composition WC-C est comprise entre 0,3 et 10µm et avantageusement 0,8µm pour la plupart des applications, à l'exception de celles nécessitant des épaisseurs plus importantes comme pour les segments

Selon une autre caractéristique, le revêtement DLC a une épaisseur comprise entre 1 à 20µm

L'invention concerne également une pièce de frottement revêtue de DLC appliqué sur une couche à gradient de composition WC-C que présente la pièce décapée par technologie micro-onde.

L'invention est exposée ci-après plus en détail à l'aide des dessins annexé dans lesquels :
- la figure 1 est une vue du profil de rupture du revêment selon la méthode de scratch test.
- La figure 2 est une vue en coupe selon la ligne A-A de la figure 1 dans le cas d'un écaillage adhésif.
- La figure 3 est une vue en coupe selon la ligne A-A de la figure 1, dans le cas d'un écaillage cohésif.La figure 4 est une vue coupe selon la ligne A-A de la figure 1 dans le cas d'un écaillage cohéso-adhésif.

Comme indiqué, l'état de la technique décrit des revêtements de DLC incluant, dans tous les cas une sous-couche d'adhérence faite par exemple en Cr pur, suivie d'une couche à base de carbure de tungstène dans laquelle la teneur en carbone est augmentée progressivement jusqu'à l'obtention d'une couche de DLC et dopée de tungstène, avec pour objectif d'assurer l'adhérence d'un dépôt de DLC non dopé par du métal.

Dans le cadre de l'invention, des essais ont été effectués afin de comparer les résultats obtenus dans le cas de réalisations de revêtements de DLC avec une ou plusieurs sous-couches d'adhérence et de revêtement DLC n'utilisant pas de couche d'adhérence selon les caractéristiques de l'invention.

Des dépôts ont été effectués sur des substrats métalliques ayant subi préalablement un décapage ionique pour éliminer l'oxyde superficiel afin de favoriser l'adhérence du revêtement. Différentes technologies de décapage ionique sont connues par l'homme du métier, à savoir essentiellement la technologie diode, la technologie triode de plasma amplifié, et la technologie triode système micro-ondes ECR.

La technologie diode consiste à appliquer une tension négative aux substrats de quelques centaines de volts (<-500V), dans une atmosphère d'argon de 1 à 10 Pa. Dans ces conditions, une décharge luminescente apparaît autour des pièces, à partir de laquelle les ions argon positifs du plasma bombardent la surface du substrat permettant la pulvérisation de la surface et l'élimination de l'oxyde.

Dans la technologie triode de plasma amplifié, un plasma d'argon dense à plus basse pression (0,1 à 1 Pa), est généré par un dispositif d'amplification de plasma. Les ions argon positifs du plasma sont accélérés par une polarisation négative du substrat et décapent la surface. Pour ce type de procédé, la tension négative doit être comprise entre -250V et -500V pour montrer son maximum d'efficacité en terme de décapage.

La technologie triode système micro-onde ECR permet de générer un plasma d'argon dans une plage de pression comprise entre 0,05 et 0,5 Pa. Les pièces sont polarisées à une tension négative comprise de façon optimale entre -50V et - 250V.

Pour ces essais, chacune des technologies de décapage a été utilisée. Suite au décapage, sur une partie des éprouvettes, une sous-couche d'adhérence de chrome pur a été réalisée par pulvérisation cathodique magnétron, pour obtenir une épaisseur de chrome de l'ordre de 0,1 à 0,2 µm. Sur l'ensemble des éprouvettes, on a ensuite procédé à un dépôt de carbure de tungstène par pulvérisation cathodique magnétron, en introduisant progressivement un débit croissant d'hydrocarbure, permettant l'enrichissement du dépôt en carbone à une teneur supérieure à 50% atomique pour permettre l'adhérence de la couche finale de DLC. La couche contenant du tungstène a une épaisseur de l'ordre de 0,5 µm et celle du DLC de l'ordre de 2µm à l'exception des exemples 9 et 10, pour lesquels l'épaisseur de la couche contenant du tungstène est augmentée à 1,5µm.

Le tableau suivant récapitule les conditions d'essai.

| **Technologie de décapage** | **Présence d'une couche d'adhérence de Cr** |
|---|---|
| Diode | Oui |
| Diode | Non |
| Triode amplifié | Oui |
| Triode amplifié | Non |
| Triode ECR | Oui |
| Triode ECR | Non |

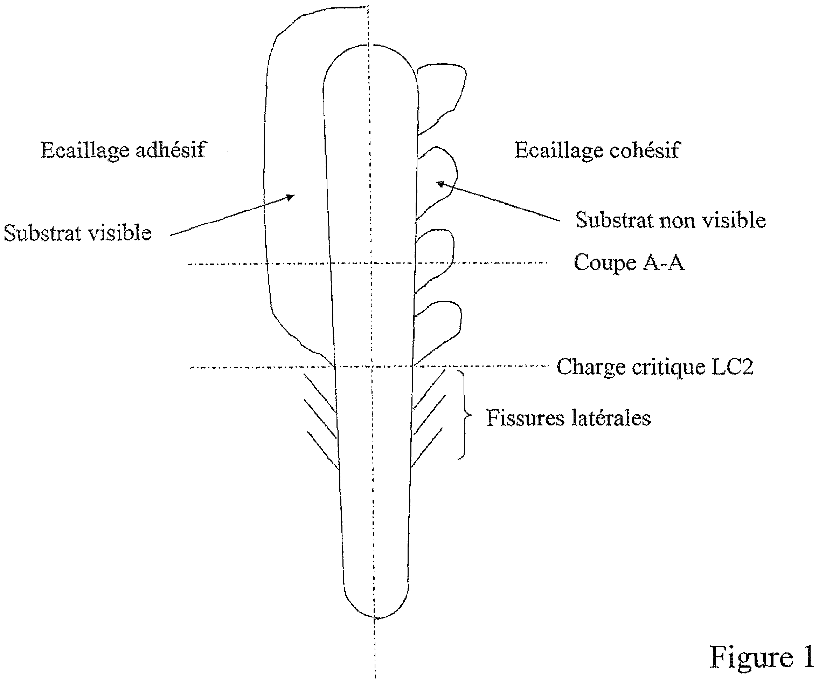

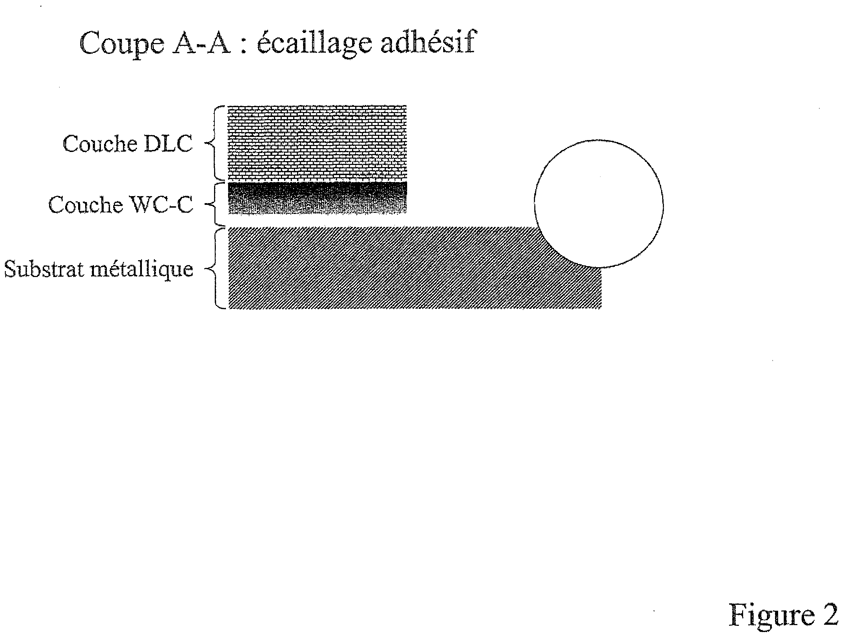

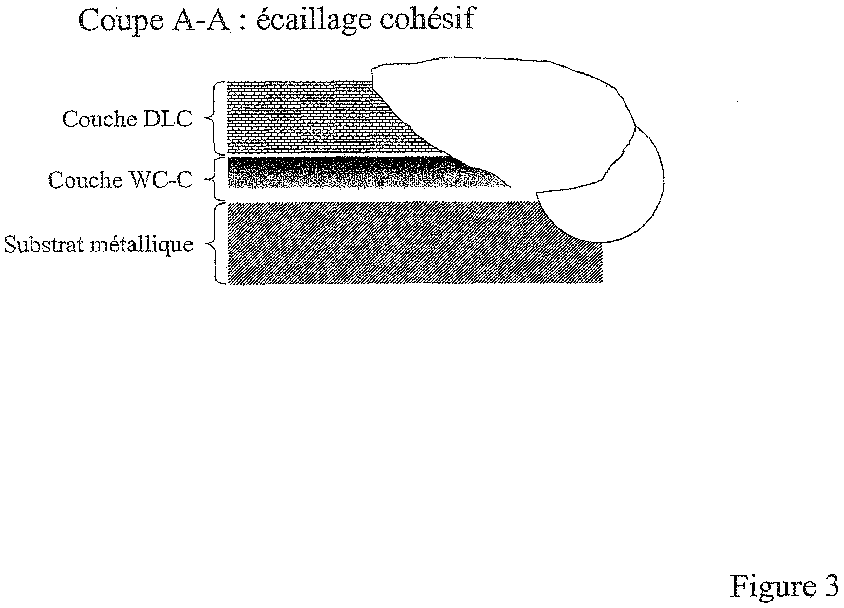

L'ensemble des revêtements a été caractérisé en terme d'adhérence. Ainsi, la méthode du scratch test a été utilisée. On rappelle que cette méthode consiste à rayer la surface du dépôt avec un diamant tel que ceux utilisés en indentation HRC. Une charge progressivement croissante est appliquée tandis, que l'éprouvette est translatée à vitesse constante sous le diamant. Ceci permet d'obtenir une rayure à charge croissante (figure 1) à partir de laquelle il est possible de déterminer une force d'écaillage (charge critique), ainsi que le mode d'écaillage. Le mode d'écaillage indique la localisation de la rupture du revêtement. Il existe 2 grandes familles d'écaillages :
- l'écaillage adhésif (figure 2)
- l'écaillage cohésif (figure 3)

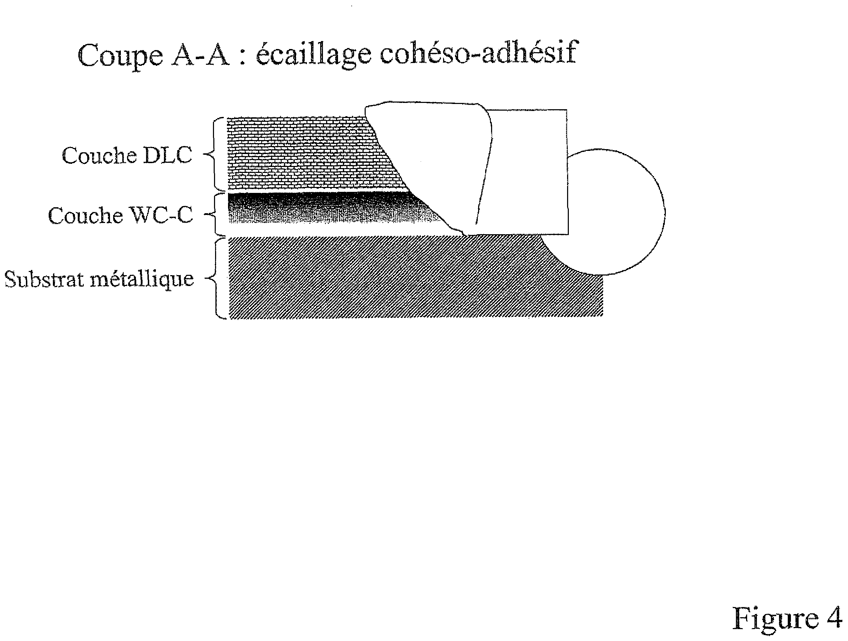

Il existe un mode mixte combinant une rupture adhésive à une rupture cohésive dénommée adhéso-cohésive (figure 4).

L'écaillage adhésif correspond à la propagation de fissures le long d'une interface, donc parallèle à la surface de la pièce, tandis que l'écaillage cohésif se propage au travers du revêtement sous un angle oblique par rapport aux interfaces. L'écaillage adhésif caractérise un défaut d'adhérence du revêtement. L'écaillage cohésif intervient lorsque les contraintes dépassent la limite à rupture des matériaux constituant le revêtement.

Dans le cas du faciès adhésif, la charge critique caractérise la force d'adhérence.

Dans le cas d'une rupture cohésive, on ne caractérise pas l'adhérence, mais la résistance à la rupture du revêtement. La charge critique est non seulement une caractéristique du dépôt, mais aussi une caractéristique de son épaisseur et de la dureté du substrat.

Une seconde méthode pour évaluer l'adhérence a été utilisée. Elle consiste à indenter le dépôt à l'aide d'un diamant Vickers sous une charge de 2kg.

Dans le tableau suivant, on a repris la matrice d'expériences en incluant les résultats du scratch test, obtenus sur des substrats en acier à outil (dureté 64HRC), pour des épaisseurs totales de dépôt de 2,5µm sans sous-couche de chrome et de 2,7µm d'épaisseur avec sous-couche de chrome et une épaisseur totale de 3,5 µm pour les exemples 9 et 10. Les exemples 11 et 12 présentent des empilements d'épaisseur forte, démontrant la robustesse de l'invention. L'exemple 11 comporte une couche à base de tungstène de 4µm d'épaisseur sur laquelle 8µm de DLC a été déposé. Pour l'exemple 12, l'épaisseur de la couche de tungstène a été portée à 9,7 µm et la couche superficielle de DLC à 19,2 µm.

| Exemple | Technologie de décapage | Présence d'une couche d'adhérence de Cr | Pression de décapage en Pa | Charge critique en N | Faciès | Identation Vicker sous 2kg (20N) |
|---|---|---|---|---|---|---|
| 1. | Diode | Oui | 2 | 32 | C | RAS |
| 2. | Diode | Non | 2 | 6 | A | RAS |
| 3. | Triode amplifié | Oui | 0,6 | 33 | C | RAS |
| 4. | Triode amplifié | Non | 0,6 | 8 | A | RAS |
| 5. | Triode amplifié | Non | 0,4 | 18 | CA | RAS |
| 6. | Triode ECR | Oui | 0,5 | 32 | C | RAS |
| 7. | Triode ECR | Non | 0,5 | 18 | CA | RAS |
| 8. | Triode ECR | Non | 0,3 | 31 | C | RAS |
| 9. | Triode ECR | Non | 0,3 | 36 | C | RAS |
| 10. | Triode ECR | Non | 0,3 | 35 | C | RAS |
| 11. | Triode ECR | Non | 0,3 | 44 | C | RAS |
| 12. | Triode ECR | Non | 0,3 | 55 | C | RAS |

| | | | | | | |
|---|---|---|---|---|---|---|
| C = cohésif A = adhésif CA = cohéso-adhésif RAS = aucun décollement du dépôt | | | | | | |

Il ressort de ce tableau que dans le cas d'un décapage diode, et comme l'enseigne l'état de la technique, la sous-couche de chrome permet d'avoir une forte adhérence (exemple 1) et qu'en son absence, la rupture intervient à l'interface entre le WC et l'acier (exemple 2).

L'utilisation de la technologie de décapage triode amplifié, montre une évolution du comportement du dépôt à la rayure en l'absence de sous couche de chrome (exemples 4 et 5). La charge critique a augmenté par rapport au décapage diode (exemple 2) et le mode d'écaillage a évolué (exemples 4 et 5).

L'observation des éclats montre un mode intermédiaire d'écaillage.

Selon l'invention, l'utilisation de la technologie triode micro-onde ECR, montre qu'il est possible d'obtenir un comportement mécanique tout à fait similaire à l'état de la technique, en l'absence de sous-couche de chrome (exemple 8). On remarque, comme en technologie triode amplifiée, que l'abaissement de pression se traduit par une amélioration du comportement au scratch test (exemples 7 et 8).

Les exemples 9 et 10 enseignent que la résistance à l'écaillage cohésif est augmentée par le biais de l'épaisseur de la sous-couche contenant du tungstène, comme le montrent les valeurs de charge critique. Dans les deux exemples, l'épaisseur du carbure de tungstène et de la couche à gradient est de 1,5 µm. Plus particulièrement, dans l'exemple 9, l'épaisseur du carbure de tungstène a été portée à 1µm, celle correspondant au gradient de teneur en carbone est de 0,5 µm. Dans l'exemple 10, l'épaisseur du carbure de tungstène est de 0,2 µm, tandis que la couche à gradient de teneur de carbone est portée à 1,3 µm.

Les exemples 11 et 12 illustrent la robustesse de la solution. Il est connu que l'augmentation de l'épaisseur des couches minces dures déposées sous vide se traduit par l'augmentation des contraintes internes de compression. Néanmoins, le comportement en scratch test reste cohésif et l'augmentation de la charge critique résulte de l'augmentation d'épaisseur de la couche à base de tungstène.

Au-delà de la technologie de décapage, les résultats tendent à montrer une amélioration de l'adhérence des couches réalisées sans sous-couche chrome lorsque la pression de décapage diminue. La diminution de pression, pendant le décapage, dépend de la technologie elle-même. Typiquement, la technologie diode est incapable de générer un plasma à des pressions aussi basses que 0,5 Pa.

Ainsi selon l'invention, l'utilisation d'une technologie de décapage appropriée, permet de réduire la pression d'argon, et de réaliser un empilement adhérant de type DLC sans sous-couche chrome, ce qui va à l'encontre des connaissances générales de l'homme du métier et des solutions techniques antérieures.

Le procédé selon l'invention apporte de nombreux avantages :
Outre la simplification de l'équipement et la réduction de son coût, la suppression de la sous-couche d'adhérence entraîne la disparition de d'une interface et donc une augmentation de la fiabilité et de la robustesse du revêtement.
On observe également, comme il ressort des essais effectués, que la sous-couche de chrome tend à masquer les déficiences de certains décapages contrairement au carbure tungstène qui semble nécessiter un décapage plus efficace, afin d'être aussi performant sur le plan de l'adhérence qu'un dépôt réalisé avec une sous-couche de chrome.
Par ailleurs, l'utilisation d'une indentation Vickers sous 2 kg n'a pas permis de mettre en évidence les différences d'adhérence des différents types de dépôt. Bien que la charge appliquée soit de 2kg (20N), la déformation induite par le diamant Vickers n'est pas suffisante pour induire le décollement des dépôts, comme dans l'exemple 2, dont l'adhérence est pourtant mise à défaut par la méthode du scratch test.

## Revendications

1. Pièce métallique présentant une couche à gradient de composition WC-C, à l'exception d'une sous-couche métallique et à l'exception d'une couche d'implantation ionique et une couche superficielle de DLC, **caractérisée par** un comportement cohésif en scratch test.

2. Pièce selon la revendication 1 revêtue de DLC appliqué sur une couche à gradient de composition WC-C que présente la pièce décapée par une technologie micro-onde.

3. Procédé d'application d'un revêtement DLC sur une pièce métallique **caractérisé par** les étapes suivantes :
- on réalise un décapage micro-onde,
- on soumet la pièce à une couche à gradient de composition WC-C,
- on applique sur la couche WC-C le revêtement DLC par plasma micro-onde.

4. Procédé selon la revendication 3, **caractérisé en ce qu'**on génère un plasma d'argon pour le décapage dans une plage de pression, comprise entre 0,05 et 0,5 Pa.

5. Procédé selon la revendication 3, **caractérisé en ce qu'**on réalise la couche à gradient de composition WC-C par PVD magnéton.

6. Procédé selon la revendication 5, **caractérisé en ce qu'**on part d'une première couche de WC pur suivie d'une rampe de débit d'un hydrocarbure et suivie en final d'une couche WC-C.

7. Procédé selon l'une quelconque des revendications 5 et 6, **caractérisé en ce que** l'épaisseur de la couche à gradient de composition WC-C est comprise entre 0,3 et 10 µm et avantageusement 0,8 µm.

8. Procédé selon la revendication 3, **caractérisé en ce que** le revêtement DLC a une épaisseur comprise entre 1 et 20 µm.

## Patentansprüche

1. Metallteil mit einer Gradientenschicht aus WC/C-Zusammensetzung, mit Ausnahme einer metallischen Unterschicht und mit Ausnahme einer Ionenimplantationsschicht und einer DLC-Oberflächenschicht, **gekennzeichnet durch** ein kohäsives Verhalten beim Scratchtest.

2. Teil nach Anspruch 1 mit DLC-Beschichtung, die auf eine Gradientenschicht aus WC/C-Zusammensetzung aufgebracht wird, welche das durch Mikrowellentechnik geäzte Teil aufweist.

3. Verfahren zum Aufbringen einer DLC-Beschichtung auf ein Metallteil, das durch folgende Vorgänge gekennzeichnet ist:
- es wird eine Mikrowellen-Ätzung durchgeführt,
- das Teil wird einer Gradientenschicht aus WC/C-Zusammensetzung unterzogen,
- auf die WC/C-Schicht wird die DLC-Beschichtung durch Mikrowellenplasma aufgebracht.

4. Verfahren nach Anspruch 3, **dadurch gekennzeichnet, dass** zum Ätzen ein Argon-Plasma in einem Druckbereich zwischen 0,05 und 0,5 Pa generiert wird.

5. Verfahren nach Anspruch 3, **dadurch gekennzeichnet, dass** die Gradientenschicht aus WC/C-Zusammensetzung durch PVD Magnetron erzielt wird.

6. Verfahren nach Anspruch 5, **dadurch gekennzeichnet, dass** von einer ersten, reinen WC-Schicht, gefolgt von einer Rampen-Anstiegsrate eines Kohlenwasserstoffs und zuletzt gefolgt von einer WC/C-Schicht ausgegangen wird.

7. Verfahren nach einem der Ansprüche 5 und 6, **dadurch gekennzeichnet, dass** die Gradientenschicht aus WC/C-Zusammensetzung 0,3 bis 10 µm und vorzugsweise 0,8 µm dick ist.

8. Verfahren nach Anspruch 3, **dadurch gekennzeichnet, dass** die DLC-Beschichtung 1 bis 20 µm dick ist.

## Claims

1. Metal part having a layer with a WC-C compound gradient, with the exception of a metallic sub-layer and with the exception of an ion implantation layer and a DLC surface layer, **characterised by** a cohesive behaviour in scratch tests.

2. Part as claimed in claim 1 covered in a DLC coating applied to a WC-C compound gradient layer which the microwave cleaned part etched has.

3. Method for applying a DLC coating to a metal part **characterised by** the following steps:
- The part is microwave cleaned,
- The part is subjected to a WC-C compound gradient layer,
- The DLC coating is applied to the WC-C layer by a microwave plasma.

4. Method as claimed in claim 3, **characterised in that** an argon plasma is generated in order to clean over a pressure range of 0.05 to 0.5 Pa.

5. Method as claimed in claim 3, **characterised in that** the WC-C compound gradient layer is produced by magnetron PVD.

6. Method as claimed in claim 5, **characterised in that** one starts with a first pure WC layer followed by a hydrocarbon flow rate ramp finally followed by a WC-C layer.

7. Method as claimed in either claim 5 or 6, **characterised in that** the thickness of the WC-C compound gradient layer is 0.3 to 10 µm and advantageously 0.8 µm.

8. Method as claimed in claim 3, **characterised in that** the DLC coating has a thickness of 1 to 20 µm.
